# EUROPEAN PATENT APPLICATION

(11) **EP 0 709 885 A2**
(43) Date of publication of application: **01.05.1996**
(21) Application number: 95307538.9
(22) Date of filing: 24.10.1995
(51) Int. Cl.: H01L 23/473, H01L 23/467

(54) **Circuit pack with integrated closed-loop cooling system**

(30) Priority: 31.10.1994 US 332223
(71) Applicant: AT&T Corp., New York, NY 10013-2412 (US)
(72) Inventor: Azar, Kaveh, Westwood, Massachusetts 02090 (US)
(74) Representative: Johnston, Kenneth Graham

(57) **Abstract**

A circuit pack with an integrated closed loop cooling system, the circuit pack comprising: a substrate; at least one heat-producing component mounted on the substrate; cooling units provided for predetermined ones of at least one heat-producing component in heat conductive relationship therewith; a delivery system for delivery of a cooling fluid to and from the cooling units; and a cooling fluid mover coupled to the substrate for circulating the cooling fluid through the delivery system and the cooling units. In an illustrative example of the invention, a heat exchanger and cooling fluid reservoir are coupled to the delivery system to enhance the performance of the integrated closed-loop cooling system in certain applications of the invention.

## Description

### Cross Reference to Related Application

United States patent application Serial Number 08/332222 was filed concurrently herewith.

### Technical Field

This invention relates to the cooling of heat-producing devices. More particularly, this invention relates to a circuit pack having an integrated closed-loop cooling system.

### Background of the Invention

Effectively dissipating the heat produced by the operation of microelectronic devices, such as integrated circuit ("ICs"), is an important concern in optimizing the performance of the circuitry in which those devices are used. In addition to optimizing performance, effective heat dissipation also helps to prolong the useful life of those devices and enhances both device and overall system reliability.

IC devices typically include an active semiconductor die encapsulated in a plastic package. The plastic package provides mechanical protection to the die and dissipates heat generated by the die during operation. One or more IC devices are electrically interconnected and mounted on a common substrate, such as a printed circuit board, to form a circuit pack. A heat sink, typically made of metal having high thermal conductivity, may be attached to the outer surface of each of the packages to aid in heat dissipation. Such heat sinks often utilize an array of elongated fins arranged on a common platform where the platform is then bonded or mechanically attached to the top of the IC package. Cooling fluid, such as air, conducts heat away from the IC package and heat sink by means of forced or natural convection. Unfortunately, such cooling arrangements afford limited cooling capacity and thus, may not be able to adequately dissipate the heat generated by today's high-powered circuit packs in certain applications.

### Summary of the Invention

The need for adequate heat dissipation in circuits packs noted above is satisfied, in accordance with the invention. by providing a circuit pack with an integrated closed-loop cooling system, such a circuit pack comprising: a substrate; at least one heat-producing component mounted on the substrate; cooling units provided for predetermined ones of at least one heat-producing component in heat conductive relationship therewith; a delivery system for delivery of a cooling fluid to and from the cooling units; and a cooling fluid mover coupled to the substrate for circulating the cooling fluid through the delivery system and the cooling units.

In an illustrative example of the invention, a heat exchanger and cooling fluid reservoir are coupled to the delivery system to enhance the performance of the integrated closed-loop cooling system in certain applications of the invention.

### Brief Description of the Drawings

FIG. 1 is a simplified block diagram of a closed-loop cooling system, the principles of which are embodied in the present invention.

FIG. 2 is a pictorial representation of an illustrative example of a circuit pack having an integrated closed-loop cooling system, in accordance with the invention.

FIG. 3 is a simplified schematic diagram of the circuit pack shown in FIG. 2.

FIG. 4 shows an illustrative example of the invention having a heat exchanger and cooling fluid reservoir.

FIG. 5 shows an illustrative example of the invention with a manifold delivery system.

FIG. 6 shows an illustrative example of the invention with a multiple-loop delivery system.

### Detailed Description

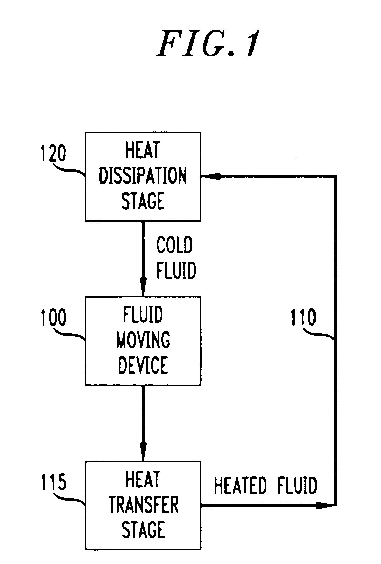

FIG. 1 is a simplified block diagram of a closed-loop cooling system, the principles of which are embodied in the present invention. As shown, a fluid is continously circulated by a fluid moving device 100 around a closed-loop 110 coupling a heat transfer stage 115 and a heat dissipation stage 120. The system is "closed" because cooling fluid never leaves the system. Heat, from some heat source (not shown) is transferred to the fluid in the heat transfer stage 115 and dissipated by the fluid in the heat dissipation stage 120.

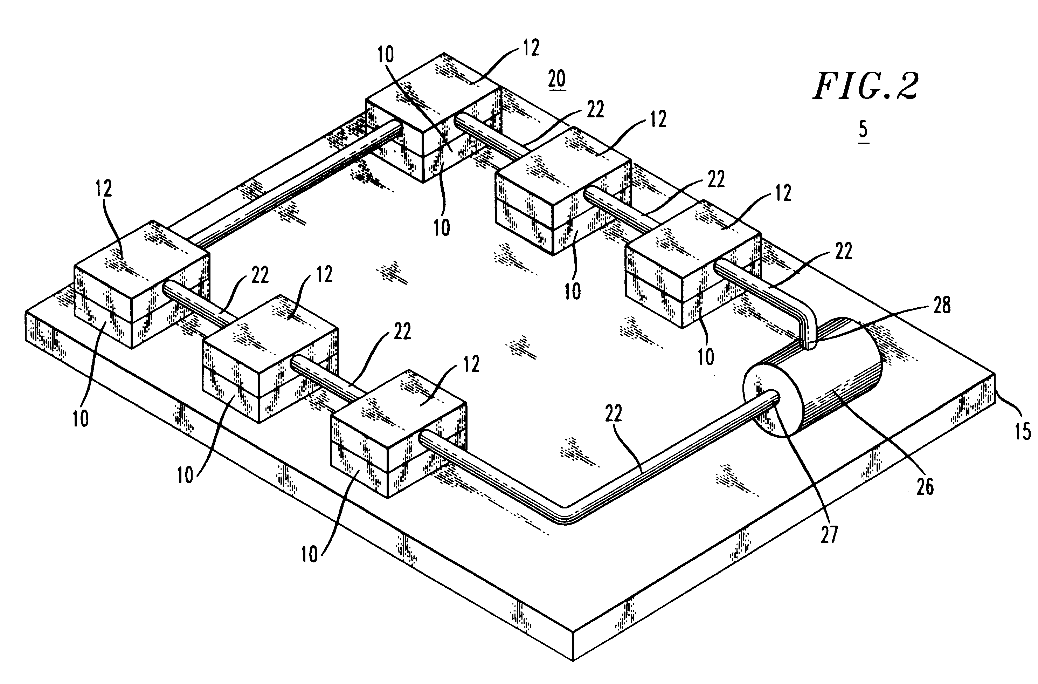

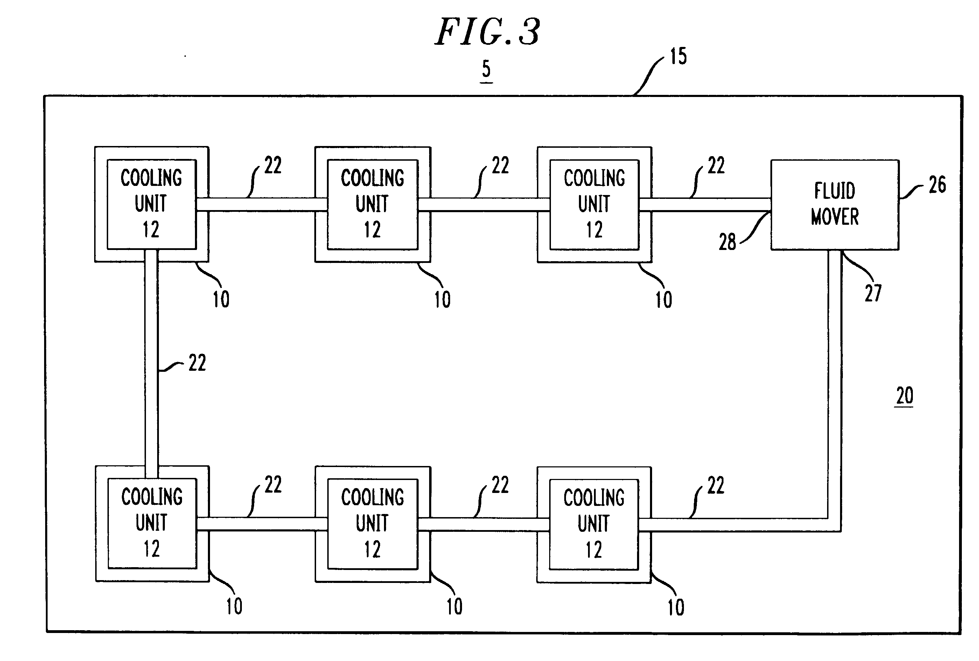

FIG. 2 is a simplified pictorial representation of an illustrative example of a circuit pack 5 having an integrated closed-loop cooling system, in accordance with the invention. FIG. 3 is a simplified schematic diagram of circuit pack 5. It should be noted at the onset that the term "circuit-pack" as used herein refers to devices which typically comprise a plurality of electrically interconnected integrated circuits ("ICs") mounted on a common substrate such as a printed circuit board. These devices are often called "cards" or "boards" and are typically installed in slots in some larger electronic system such as computers, televisions, telephone switches, and the like. Modem cards and video boards for personal computers are well known examples of circuit packs. Furthermore, the term "integrated closed-loop cooling system" as used herein refers to an arrangement where a complete closed-loop cooling system is directly incorporated into the circuit pack without requiring connections, other than power, to systems or components external to the circuit pack in order to perform the desired cooling function. It should also be noted that heretofore closed-loop cooling has been provided to heat-producing components using apparatus that is at least partially remotely located from the circuit pack and typically centralized so as to provide electronic system-level cooling for components located on different circuit packs.

The circuit pack having an integrated closed-loop cooling system of the present invention provides a number of advantages: 1) Simplified electronic system repair - If a particular circuit pack in the system fails, a replacement circuit pack can be readily installed since no plumbing connections need to be broken or made to a central cooling system to effectuate the replacement. Furthermore, no cooling system integrity test would need to be performed after installation of the replacement circuit pack thus saving on system downtime; 2) Ease of cooling system troubleshooting - Since cooling systems are distributed among multiple circuit packs within the electronic system, in accordance with the present invention, a failure such as a cooling fluid leak would be limited to a single circuit pack; 3) Ease of cooling system capacity optimization - Nearly ideal matching between cooling capacity and demand may be implemented using the present invention because only circuit packs that require improved cooling need to be so cooled. This is in marked contrast to known centralized cooling arrangements which are generally designed to support "worst case" cooling situations, which results in excess cooling capacity in most typical installations; 4) Ease of electronic system design and implementation - Because each circuit pack in the electronic system has an integrated cooling system, there are no concerns as to its proximity to cooling fluid supply and return that exist in centralized cooling systems; and 5) Reduced costs - Significant cost saving may be realized due to savings in electronic system design time, and cooling system diagnosis and repair time. Capacity optimization may also reduce cooling system component costs. These and other advantages will become apparent in light of the detailed discussion of the invention which follows.

While it is intended that the various components of circuit pack 5, which are discussed in detail below, be sufficiently miniature to effect a closed-loop cooling system that is integrated on a circuit pack, it will be appreciated by those skilled in the art that the specific size and dimensions of the various components, as well as operating parameters such pressure and flow rates, are dependent upon the particular application of the invention. Accordingly, specific component sizes and dimensions and operating parameters may be readily selected based on generally known principles of heat transfer and fluid dynamics.

As shown in FIGs. 2 and 3, a circuit pack 5 includes a plurality of heat-producing components 10 which are located on a substrate 15. Circuit pack 5 may also include various other electrical and mechanical components (not shown) that are typically employed in circuit packs. Heat-producing components 10 could be, for example, integrated circuit devices. Substrate 15 would typically be a printed circuit board. Each of the heat producing components 10 is equipped with a cooling unit 12 that is in heat conductive contact with the heat-producing component. Cooling units are devices that remove heat from heat-producing electronic components, and often have provision for utilizing a cooling fluid of some kind. Cooling units are well known and include, for example, cooling members as described in United States patent 4,558,395 by Yamada et al., the disclosure of which is incorporated by reference herein. Alternatively, cooling units may be, for example, integrated into the package of components 10 as described in my co-pending United States application Serial Number (K. Azar Case 13), filed on the same day as the present application, the disclosure of which is incorporated by reference herein. Cooling units 12 may be formed, for example, using metals having high thermal conductivity such as copper, steel, and aluminum. Alternatively, cooling units 12 may be formed using plastic, glass, or ceramic materials. Although each heat-producing component 10 is shown with its own individual cooling unit 12, it should also be noted that a cooling unit 12 may be sized and located to provide cooling to more than one heat-producing component 10.

Circuit pack 5 also includes a delivery system 20, which in this illustrative example of the invention, comprises a plurality of cooling pipe segments 22 serially connected between adjacent cooling units 12. Cooling pipe segments 22 may be formed from any of the many tubing types that are known in art for their ability to carrying cooling fluids. Accordingly, cooling pipe segments 22 may be, for example, steel, stainless steel, copper, aluminum, plastic, or combinations thereof. Cooling pipe segments 22 are coupled to cooling units 12 in a fluid-tight manner. For example, the coupling could be threaded, adhesive-bonded, brazed, welded, soldered, friction-fit, molded, or press-fit according to the particular materials chosen for cooling units 12 and cooling pipe segments 22.

Cooling fluid mover 26, having an intake port 27 and discharge port 28, is coupled via these ports, as shown, to cooling pipe segments 22 to effect a single pass closed-loop cooling system. Cooling fluid mover 26 may be, for example, a pump, siphon, turbine, or compressor. These devices, having appropriate sizes for application to the present invention, are known. Cooling fluid mover 26 circulates a cooling fluid (not shown) through cooling pipe segments 22 and cooling units 12 in a continuous loop so that heat generated by the heat-producing components 10 is transferred to the cooling fluid in cooling units 12. The cooling fluid can be a gas or liquid. Preferably, the cooling fluid is a liquid, such as water, due to its greater thermal conductivity as compared to gases. In some applications of the invention, it may also be desirable to use an inert, electrically non-conducting liquid as the cooling fluid. One suitable liquid cooling fluid is commercially available under the designation FLUORINERT FC-77 by the 3M Corporation.

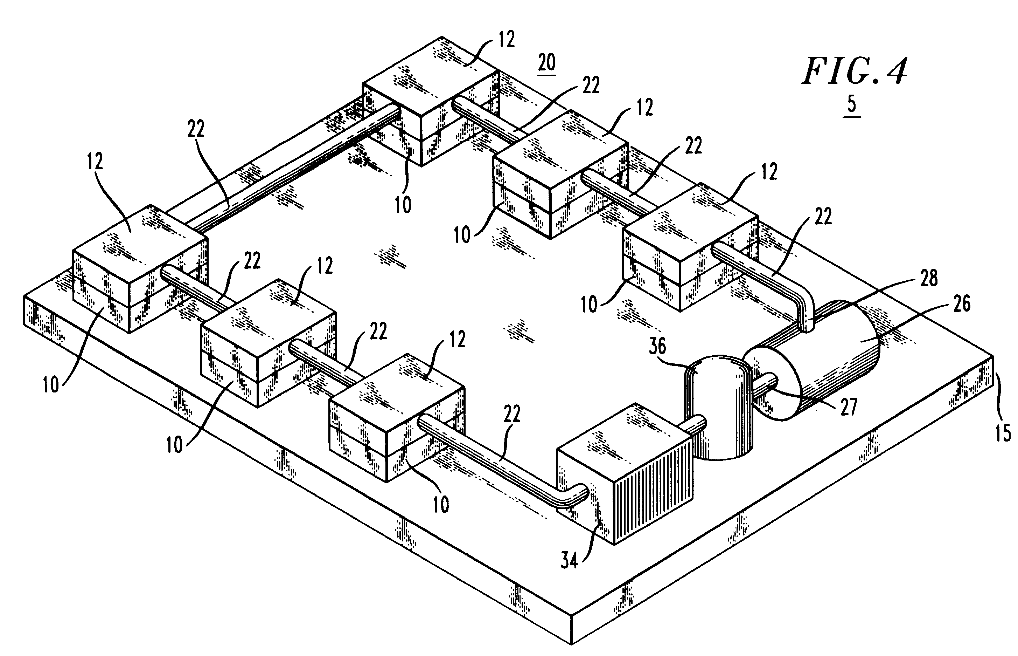

It will be appreciated by those skilled in the art that the heat carried by the cooling fluid will be dissipated to the ambient surroundings via natural convection as it circulates through cooling pipe segments 22 and cooling fluid mover 26. Depending upon the length and diameter of cooling pipe segments 22, and the size and material composition of fluid mover 26, this heat dissipation can be substantial, particularly if forced convection is utilized. Additionally, external heat sinks may be attached to cooling pipe segments 22 and cooling fluid mover 26 to increase the effective heat dissipative surface area for these components. However, it may be desirable in some applications to include a heat exchanger 34 in the closed-loop cooling system, as shown in FIG. 3, to further enhance the dissipation of heat from the cooling fluid. Heat exchangers are well known, and may include, for example, coiled tube, finned tube, plates, shell and tube, and U-tube designs. Heat exchanger 34, as shown in FIG. 4 is multiple row finned tube design. Heat exchanger 34 may be air or liquid cooled. If air cooled, then natural or forced convection may be utilized.

It may also be desirable to include a cooling fluid reservoir 36 in the closed-loop cooling system, as shown in FIG. 4. Cooling fluid reservoir 36 serves to increase the volume of fluid available for cooling purposes thereby increasing the cooling capacity of the cooling system, and may be used to promote mixing between cooling fluid returning from cooling units 12 and the cooling fluid held in the reservoir 36. Such cooling fluid reservoirs are known. Conventional heat sinks may be attached to the exterior of cooling fluid reservoir 36 to provide a further heat dissipation path for the cooling fluid, if desired. Cooling fluid reservoir 36 may also be equipped with known filter arrangements to remove contaminants or other foreign substances from cooling fluid 32.

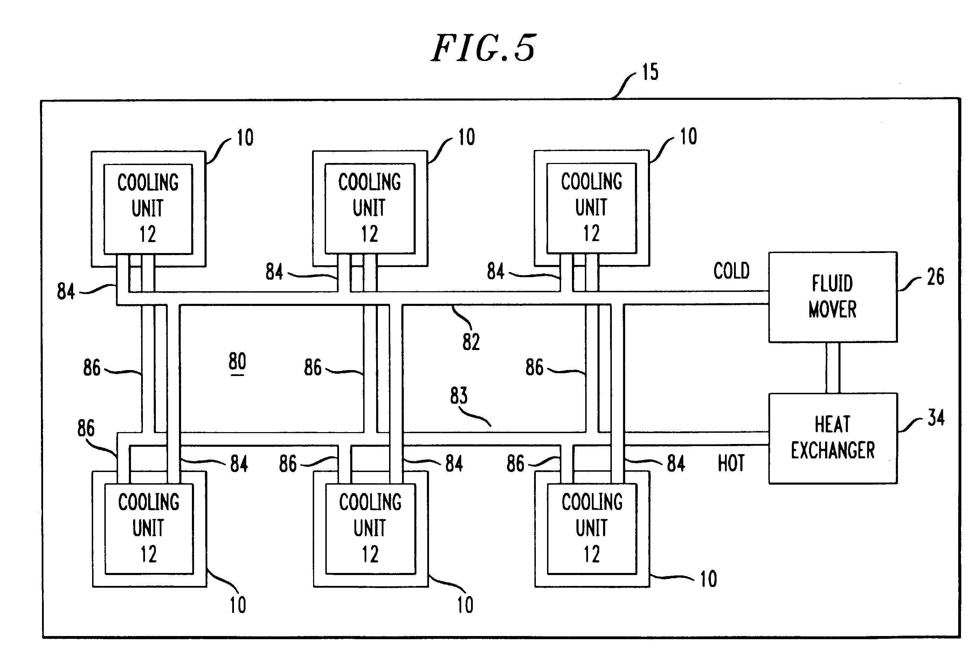

FIG. 5 shows another illustrative arrangement of a delivery system, in accordance with the invention. Delivery system 80 comprises a main supply manifold 82 and main return manifold 83. Heat exchanger 34 is also shown in FIG. 5. Of course, as in the illustrative example of the invention shown in FIG. 3, heat exchanger 34 should be considered optional. Secondary supply lines 84 and secondary return lines 86 couple the main supply manifold 82 and main return manifold 83, respectively, to the individual cooling units 12 as shown. Cold cooling fluid is discharged from fluid mover 26 into the main supply manifold 82 where it is circulated through the cooling units 12. The hot cooling fluid is then returned to heat exchanger 34 via main return manifold 83 as shown. The manifolds and supply lines may be formed from the same materials as the cooling pipe segments 22 described when referring to FIG. 2. The above described manifold delivery arrangement may be useful, for example, in situations where the layout of the heat-producing components 10 on substrate 15 is such as to prevent serial connection of the cooling pipes. Alternatively, a manifold delivery arrangement may be desirable for the uniform cooling it provides to cooling units 12, recognizing of course, that the above-described single pass system may provide non-uniform cooling in certain instances.

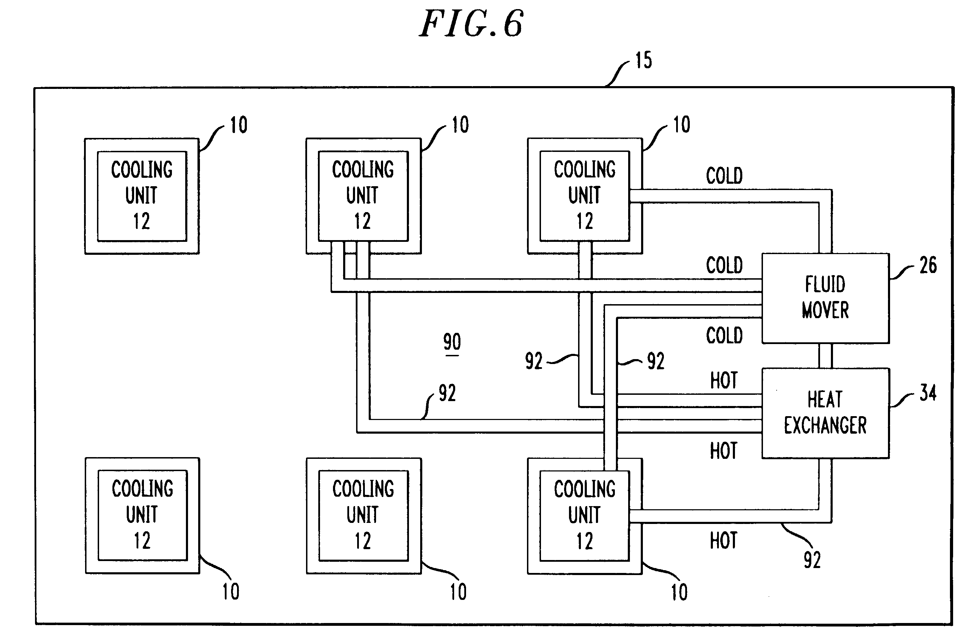

FIG. 6 shows another illustrative arrangement of a delivery system, in accordance with the invention. Delivery system 90 comprises a plurality of cooling loops 92 where each cooling loop couples individual cooling units 12 to fluid mover 26 and heat exchanger 34 as shown to effect a multiple-loop delivery system. For clarity in illustration, only three cooling units 12 are shown coupled to the delivery system. Such a delivery system may be useful in order to accomodate particular circuit pack layouts that are not suited to the above-described single-pass and manifold delivery system. Of course, those skilled in the art will appreciate that various combinations of the delivery systems described herein may also be utilized in such situations. Multiple fluid movers, cooling fluid reservoirs, and heat exchangers may also be incorporated onto a single circuit pack.

It will be understood that the particular techniques described above are only illustrative of the principles of the present invention, and that various modifications could be made by those skilled in the art without departing from the scope and spirit of the present invention, which is limited only by the claims that follow. For example, refrigerants and appropriately sized evaporators and condensers may be integrated onto a circuit pack to enhance heat dissipation from heat-producing components on the circuit pack using well known phase-change cooling techniques.

## Claims

1. A circuit pack, comprising:
a substrate;
at least one heat-producing component mounted on said substrate;
cooling units provided for predetermined ones of said at least one heat-producing component in heat conductive relationship therewith;
a delivery system for delivery of a cooling fluid to and from said cooling units; and
at least one cooling fluid mover for circulating said cooling fluid through said delivery system and said cooling units;
wherein said cooling units, said delivery system, and said cooling fluid mover are coupled to said substrate so as to provide said circuit pack with an integrated closed-loop cooling system.

2. The apparatus of claim 1 further including at least one heat exchanger coupled to said delivery system for removing heat from said cooling fluid.

3. The apparatus of claim 1 further including at least one reservoir coupled to said delivery system for containing a supply of said cooling fluid.

4. The apparatus of claim 1 wherein said cooling fluid is either a gas, or a liquid, or
an inert, electrically non-conducting liquid.

5. The apparatus of claim 1, wherein said delivery system is a single-pass system.

6. The apparatus of claim 5, wherein said single pass delivery system includes a plurality of pipe segments coupling adjacent ones of said cooling units.

7. The apparatus of claim 6, wherein each of said plurality of pipe segments are formed from a material selected from the group consisting of steel, stainless steel, copper, aluminum, plastic, or combinations thereof.

8. The apparatus of claim 1, wherein said fluid mover is selected from the group consisting of pumps, siphons, compressors, turbines.

9. The apparatus of claim 1, wherein said cooling units include means for removing heat from said predetermined ones of said at least one heat-producing component.

10. The apparatus of claim 1, wherein said delivery system is a manifold delivery system.

11. The apparatus of claim 10 wherein said manifold delivery system includes at least one main supply manifold, at least one main return manifold, and secondary supply and return lines coupling individual ones of said cooling units to respective said at least one main supply manifold and at least one main return manifold.

12. The apparatus of claim 11, wherein said manifolds and lines are formed from a material selected from the group consisting of steel, stainless steel, copper, aluminum, plastic, or combinations thereof.

13. The apparatus of claim 5, further including at least one heat sink coupled either to predetermined ones of said plurality of pipe segments, or to manifolds and predetermined ones of said lines, or to said cooling fluid mover, or to said heat exchanger, or to said reservoir.

14. The apparatus of claim 1, wherein said delivery system comprises a combination of single-pass, multiple-tube, and manifold delivery systems.

15. The apparatus of claim 1, wherein said cooling units are integrally formed in a package provided for said at least one heat-producing component.
